# EUROPEAN PATENT SPECIFICATION

(11) **EP 1 850 177 B1**
(45) Date of publication and mention of the grant of the patent: **12.06.2013**
(21) Application number: 07005628.8
(22) Date of filing: 19.03.2007
(51) Int. Cl.: G03F 7/20, G03F 1/62

(54) **Litographic pellicle**
Lithographisches Pellikel
Pellicule lithographique

(30) Priority: 25.04.2006 JP 2006120822
(43) Date of publication of application: 31.10.2007
(73) Proprietor: Shin-Etsu Chemical Co., Ltd., Tokyo (JP)
(72) Inventor: Shirasaki, Toru, Annaka-shi Gunma-ken (JP)
(74) Representative: Müller, Thomas

(56) References cited:
- EP-A1- 1 983 370
- WO-A1-2007/009543
- SAKURAI I ET AL: "PELLICLE FOR ARF EXCIMER LASER PHOTOLITHOGRAPY" 13 April 1999 (1999-04-13), PROCEEDINGS OF THE INTERNATIONAL SOCIETY FOR OPTICAL ENGINEERING (SPIE), SPIE, USA LNKD- DOI:10.1117/12.360212, PAGE(S) 177 - 187 , XP001028068 ISSN: 0277-786X * the whole document *
- BUBKE K ET AL: "Pellicle induced aberration and apodization in hyper NA optical lithography" 20 April 2006 (2006-04-20), PROCEEDINGS OF SPIE - THE INTERNATIONAL SOCIETY FOR OPTICAL ENGINEERING - PHOTOMASK AND NEXT-GENERATION LITHOGRAPHY MASK TECHNOLOGY XIII 2006 SPIE US, VOL. 6283 I , XP002587397 * the whole document *

## Description

### BACKGROUND OF THE INVENTION

### 1. Field of the Invention

The present invention relates to a lithographic pellicle or, in particular, to a lithographic pellicle used for dust-proof protection in the manufacture of semiconductor devices such as LSIs and ultra-LSIs, and liquid crystal display panels or the like. More particularly, the invention relates to a lithographic pellicle used for ultraviolet exposure of 200 nm or shorter wavelengths, which is employed in exposure where high resolution is required.

### 2. Description of the Background Art

In most cases, manufacturing of semiconductor devices such as LSIs and ultra-LSIs, and liquid crystal display panels and the like, involves patterning of semiconductor wafers or liquid crystal base plates by way of lithographic exposure to light. However, the foregoings have a problem in that dust particles deposited onto the photomask plate used in such cases absorb and reflect light, to cause deformation and roughens of the edge lines of the reproduced patterns, thereby decreasing the resolution, quality, and performance of the semiconductor devices and/or liquid crystal display panels resulting in a decrease in the productivity of the products.

Thus, these procedures are usually carried out in a clean room, but keeping always the photomask plate in a good condition inside such a clean room is difficult, and hence a pellicle is mounted onto the surface of the photomask plate as a dust-proof protector, the pellicle having herein good transparency to the exposure light.

Doing so is advantageous in that dust particles are not deposited directly onto the surface of the photomask, but are deposited onto the pellicle membrane, so that during photolithography, the dust particles on the pellicle membrane never affect the pattern reproduction, provided that the focus is set in accordance with the pattern of the photomask plate.

Herein, a transparent pellicle membrane formed from nitrocellulose, cellulose acetate or the like, and having good transmissivity is coated, dissolved in a good solvent to the pellicle membrane, onto the upper portion of a pellicle framework made of aluminum, stainless steel, polyethylene or the like, then the membrane is dried to become bonded to the pellicle framework (Japanese Patent Application Laid-open No. S58-219023); alternatively, the pellicle membrane can be bonded using an adhesive agent such as an acrylic resin (US Patent No. 4861402), an epoxy resin (Japanese Patent Examined Application Publication No. S63-27707), an amorphous fluorocarbon polymer (Japanese Patent Application Laid-open No. H07-168345) and elsewhere, while to the underside of the pellicle framework is attached an adhesive layer comprising a polybutene resin, a polyvinyl acetate resin, an acrylic resin, a silicone resin or the like, and a release layer (separator) for temporary protection of the adhesive layer.

In the wake of ever higher photolithography resolutions encountered in recent years, the light sources employed are resorting to gradually shorter wavelength in order to comply with the trend toward higher and higher resolution.

Specifically, there was a shift from ultraviolet light g-line (436 nm) to I-line (365 nm) and further to KrF excimer lasers (248 nm)), while recently ArF excimer lasers (193 nm) are at the startline of their use.

The use of shorter wavelengths in photolithography implies using light of a higher energy, for which reason transparent fluororesins, having a higher resistance to laser beams, have come to be used as pellicle membranes for KrF and ArF lasers (Japanese Patent Examined Application Publication No. S63-27707 and Japanese Patent Application Laid-open No. H07-168345).

The use of an immersion exposure device employing an ArF excimer laser for even finer processing has begun to be studied in recent years (International Patent Application No. WO99/49504). A higher NA (numerical aperture) can be accomplished by filling, with a liquid, the gap space between the objective lens of the exposure device and the silicon wafer, which as a result enables to accomplish higher resolution.

When the gap space between the objective lens and the silicon wafer is filled with pure water, the theoretical limit of the NA becomes about 1.44, but, as restricted by the lenses, among other factors, practically limited to about 1.3 the NA achievable in practice.

An exposure device having a thus increased NA affords a larger angle of inclined incidence in the parts surrounding the light passing through the pellicle membrane. Herein, the maximum angle of inclined incidence is about 15° for a NA of 1, increasing to about 19° for a NA of 1.3, with slight variations depending on the exposure device.

The transmissivity of the pellicle is designed usually so as to become the maximum to vertically incident beams, and the pellicle is prepared accordingly; transmissivity decreases, however, as the inclined incidence angle (angle formed between vertically incident beams and inclinedly incident beams) increases. The thickness of the ArF pellicles usually employed is of about 830 nm. However, transmissivities are herein significantly low, of about 96% to 15° inclination of the incident beams, and of about 92% to 19° inclined incident beams, even for a pellicle having a transmissivity of almost 100% to vertically incident beams.

A lower pellicle transmissivity, and/or a gradually decreasing transmissivity on account of the incidence angle, leads to exposure unevenness during exposure, which decreases the photolithographic quality. A lower transmissivity translates also into larger reflection on the pellicle surface, which causes a problem such as flaring or the like, thereby decreasing the photolithographic quality.

Incidence angle dependency is less prominent in thinner pellicles. In case of a thickness corresponding to a local maximum transmissivity relative to a vertically incident beam, for instance, a thickness of about 277 nm yields a transmissivity of about 99.3% to 15° inclinedly incident beams, and of about 98.6% to 19° inclinedly incident beams.

Herein, however, a thinner pellicle generally has a lower mechanical strength of the pellicle membrane, which makes pellicle manufacture difficult, or gives rise to problems such as membrane breakage in practice when the pellicle is used by mounting on a photomask.

Upon implementing ultrafine patterning by using a above-described liquid-immersion exposure device, on the other hand, there can be selectively used the inclinedly incident component alone of the incident laser beams. Employing a conventional pellicle in this case implies using the inclinedly incident components also in low-transmissivity regions, which can lead to various problems derived from the low transmissivity and high reflectivity.

Transmissivity varies from 98.6% to 99.3% for the incidence angle range of 15° to 19° practically used, while transmissivity varies from 99.3% to approximately 100% for the unused incidence angle range of 0° to 15°, i.e., transmissivity becomes unreasonably high in regions not used in practice.

Japanese Patent Examined Application Publication No. S63-27707 deals with the "average beam transmissivity" of a "dust-proof cover for a photomask", the wavelength of the studied light beams ranging therein from "240 nm to 500 nm". This document, however, is silent on the light transmissivity of inclinedly incident beams.

### SUMMARY OF THE INVENTION

In light of the above, an object of the present invention is to provide a lithographic pellicle for optimal use in the liquid-immersion exposure-type photolithography that employs selectively only the inclinedly incident component of incident laser beams, the lithographic pellicle affording a broader range of transmissivity to inclinedly incident beams that can be used in a photolithographic procedure.

The lithographic pellicle of the present invention is a lithographic pellicle for use in photolithography by using ArF excimer laser beams, which comprises a pellicle membrane having a thickness larger by 1.7% to 2.8% than a thickness with which the pellicle membrane exhibits a local maximum transmissivity to a vertically incident ArF excimer laser beam.

Further features and details of the present invention become evident from the description and the accompanied drawings.

By virtue of the pellicle membrane with a thickness larger by 1.7% to 2.8% than a thickness with which the pellicle membrane exhibits a local maximum transmissivity to a vertically incident ArF excimer laser beam, the present invention enables to provide a pellicle that can be used in high-precision exposure devices using inclinedly incident beams, greatly increasing the transmissivity of a pellicle membrane to an inclinedly incident ArF laser beam of 15° to 19° inclination.

Hence the present invention provides a lithographic pellicle for optimal use in the liquid-immersion exposure-type photolithography that employs selectively only the inclinedly incident components of incident laser beams, the lithographic pellicle affording a broader range of inclined incidence transmissivity that can be used in a photolithographic procedure. A lithographic pellicle for use in photolithography by using ArF excimer laser beams, which comprises a pellicle membrane having a thickness larger by 1.7% to 2.8% than any one of thicknesses at which the pellicle membrane exhibits a local maximum transmissivity to a vertically incident ArF excimer laser beam.

### BRIEF DESCRIPTION OF THE DRAWINGS

FIG. 1 is a graph showing the incidence angle dependency of transmissivity in a pellicle membrane (thickness 850 nm) of Example 1; and
FIG. 2 is a graph showing the incidence angle dependency of transmissivity in a pellicle membrane (thickness 830 nm) of Comparative Example 1.

### DESCRIPTION OF THE PREFERRED EMBODIMENTS

Photolithographic pellicles are usually employed under short-wavelength light, and hence are designed and prepared to have a highest transmissivity to the light of such wavelengths as a matter of course. Due to the phenomenon of interference of light, as is known, the transmissivity of membranes have local maximum values at several thickness values. While it is in general that the transmissivity of membranes to light is generally high when the thickness is small, a membrane of larger thickness has higher mechanical strength facilitating handling. Accordingly, selection of thickness for the highest performance of the pellicle membran must be based on a consideration of the balance between these two contradictory factors.

As described above, however, pellicle thickness is set so as to achieve maximum transmissivity towards vertical incidence, and hence, although the pellicle exhibits a transmissivity of approximately 100% to vertically incident beams, transmissivity decreases as the incidence angle increases, as described above, with a transmissivity of only about 92% for 19° inclinedly incident beams to be a problem when the pellicle is used in a high-NA exposure device.

When a pellicle membrane has a thickness larger by 1.7% to 2.8% than the thickness at which the pellicle membrane exhibits a local maximum transmissivity to a vertically incident ArF laser beam, the effect of greatly increasing the transmissivity of the pellicle membrane to an inclinedly incident ArF laser beam of 15° to 19° is obtained. For instance, a pellicle membrane having about 2.3% larger thickness exhibits a high transmissivity to inclinedly incident beams of 15° to 19°, inclination with a local maximum transmissivity towards inclinedly incident beams of about 17° inclination.

The thickness of the pellicle membrane is herein slightly larger than the conventional thickness, and hence does not suffer from the problem of decreased mechanical strength caused when the membrane is made thinner in order to decrease incidence angle dependency. Although the transmissivity towards vertically incident beams decreases herein considerably, these pellicles employ selectively only the inclinedly incident component of incident beams, and hence are unproblematic as they are not used in practice in the low-transmissivity range.

### EXAMPLES

Examples of the present invention are described next.

### Example 1

A 5% by mass solution prepared by dissolving a perfluoroether polymer having a cyclic structure sold in the name of Cytop CTX-S (by Asahi Glass Co.) in perfluorotributyl amine was dripped onto a silicon wafer, and was spread thereon by rotating the wafer at 830 rpm on a spin coater. The solution was then converted into a uniform film by standing for 30 minutes at room temperature and then heating at 180°C. An aluminum framework coated on the top face with an adhesive was put to the resin film and the resin film alone was lifted off from the silicon wafer to give a pellicle membrane.

A surface-anodized aluminum frame having outer dimensions of 149 mm by 122 mm by 5.8 mm height was coated on the top surface with a membrane adhesive, while the bottom surface was coated with a photomask bonding agent. Thereafter, the thus aluminum frame was put at the adhesive-coated end surface onto the pellicle membrane taken on the aluminum framework to complete a frame-supported pellicle after trimming of the film by clipping the peripheral portions extending from the aluminum frame.

The thus finished pellicle had a measured thickness of 850 nm. This thickness was larger by 2.3% than a thickness exhibiting a local maximum transmissivity to a vertically incident ArF excimer laser beam (wavelength 193 nm). This thickness exhibited a local maximum transmissivity to 17° inclinedly incident beams of an ArF laser (wavelength 193 nm).

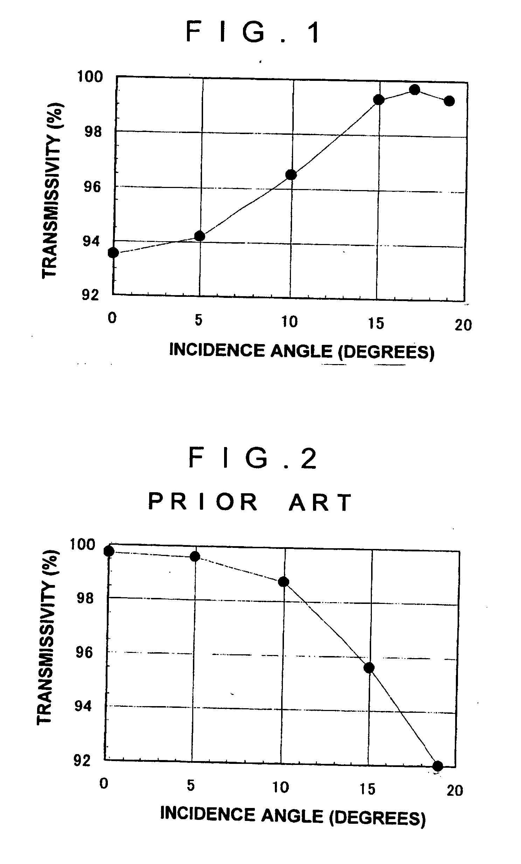

Upon measurement of the incidence angle dependency of the transmissivity, the pellicle exhibited a low transmissivity, of 93.5%, for vertical incidence (incidence angle 0°), but a high transmissivity, of 99% or higher, to inclinedly incident beams between 15° and 19°, specifically of 99.3% for 15°, 99.7% for 17°, and 99.3% for 19°. FIG. 1 illustrates the angle dependency of transmissivity in this instance.

### Comparative Example 1

A 5% by mass solution of a perfluoroether polymer having a cyclic structure Cytop CTX-S, supra, dissolved in perfluorotributylamine was dripped onto a silicon wafer, and was spread thereon by rotating the wafer at 850 rpm on a spin coater. The solution was then converted into a uniform film by standing for 30 minutes at room temperature, and then by heating at 180°C. Thereto was attached an aluminum framework coated with an adhesive agent, then the resin film alone was lifted to give a pellicle membrane.

A surface-anodized aluminum frame having outer dimensions of 149 mm by 122 mm by 5.8 mm height, coated on the top surface with a membrane adhesive and, on the bottom surface, with a photomask adhesive. Thereafter, the adhesive agent side was put to the pellicle membrane taken up on the aluminum framework, and the membrane was trimmed by clipping the peripheral portions extending from the aluminum frame to finish a framed pellicle.

The thus finished pellicle membrane had a measured thickness of 830 nm. This thickness was a thickness exhibiting a local maximum transmissivity to a vertically incident ArF excimer laser beam (wavelength 193 nm).

Upon measurement of the incidence angle dependency of the transmissivity, the pellicle exhibited a high transmissivity, of 99.7%, for vertical incidence (incidence angle 0°), but a transmissivity that decreased gradually as the incidence angle increased, of 98.7% for 10° inclinedly incident beams, 92.0% for 19° inclinedly incident beams, and of 96% or lower beyond 15° and down to 92.0%, for 19°. FIG. 2 illustrates the angle dependency of transmissivity in this instance.

The present invention, thus, enables to decrease the incidence angle dependency of pellicle transmissivity in the liquid-immersion exposure-type photolithography which selectively utilizes only the inclined incidence components of incident laser beams, and hence enables manufacturing semiconductor devices, liquid crystal display panels and the like with high productivity thereby making a significant contribution to the field of information technology.

## Claims

1. A lithographic pellicle for use in photolithography using ArF excimer laser beams, which comprises a pellicle membrane having a thickness larger by 1.7% to 2.8% than a thickness at which the pellicle membrane exhibits a local maximum transmissivity to a vertically incident ArF excimer laser beam.

## Patentansprüche

1. Lithographisches Pellicle zur Verwendung in der Photolithographie unter Verwendung von ArF-Excimer-Laserstrahlen, das eine Pellicle-Membran umfasst, die eine Dicke aufweist, die um 1,7% bis 2,8% größer ist, als eine Dicke, bei der die Pellicle-Membran eine lokale maximale Transmissivität für einen vertikal einfallenden ArF-Excimer-Laserstrahl aufweist.

## Revendications

1. Pellicule lithographique pour utilisation en photolithographie utilisant un rayon laser à excimère ArF, comprenant une membrane de pellicule ayant une épaisseur supérieure de 1,7% à 2,8% à une épaisseur à laquelle la membrane de la pellicule présente une transmissivité locale maximale à un rayon laser à excimère ArF tombant à la verticale.
